(19) **Europäisches Patentamt / European Patent Office / Office européen des brevets**

(11) **EP 2 350 891 B1**

(12) **FASCICULE DE BREVET EUROPEEN**

(45) Date de publication et mention
de la délivrance du brevet:
**22.11.2017 Bulletin 2017/47**

(21) Numéro de dépôt: **09760225.4**

(22) Date de dépôt: **27.10.2009**

(51) Int Cl.:
*G06F 17/50* $^{(2006.01)}$       *H01L 23/66* $^{(2006.01)}$

(86) Numéro de dépôt international:
**PCT/FR2009/052070**

(87) Numéro de publication internationale:
**WO 2010/049642 (06.05.2010 Gazette 2010/18)**

(54) **AUTOMATISATION DES PROCÈDÈS D'IDENTIFICATION POLE-ZERO POUR L'ANALYSE DE STABILITÉ DE CIRCUITS ACTIFS MICRO-ONDES**

VERFAHREN ZUR AUTOMATISCHEN NULLPOLIDENTIFIKATION FÜR DIE ANALYSE DER STABILITÄT AKTIVER MICROWELLENSCHALTKREISE

METHOD FOR AUTOMATIC POLE-ZERO IDENTIFICATION FOR STABILITY ANALYSIS OF ACTIVE MICROWAVE CIRCUITS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **27.10.2008 FR 0857276**

(43) Date de publication de la demande:
**03.08.2011 Bulletin 2011/31**

(73) Titulaire: **Centre National d'Etudes Spatiales
75001 Paris (FR)**

(72) Inventeurs:
* **MALLET, Alain**
  **F-31410 Mauzac (FR)**
* **ANAKABE ITURRIAGA, Aitziber**
  **E-48901 Barakaldo (Bizkaia) (ES)**
* **SOUBERCAZE-PUN, Geoffroy**
  **F-31130 Flourens (FR)**
* **COLLANTES METOLA, Juan Maria**
  **E-48003 Bilbao (ES)**

(74) Mandataire: **Lavoix
2, place d'Estienne d'Orves
75441 Paris Cedex 09 (FR)**

(56) Documents cités:
* **BARQUINERO C ET AL: "Complete Stability Analysis of Multifunction MMIC Circuits" IEEE TRANSACTIONS ON MICROWAVE THEORY AND TECHNIQUES, IEEE SERVICE CENTER, PISCATAWAY, NJ, US, vol. 55, no. 10, 1 octobre 2007 (2007-10-01), pages 2024-2033, XP011193573 ISSN: 0018-9480**
* **AYLLON N ET AL: "Sensitivity enhancement in pole-zero identification based stability analysis of microwave circuits" INTEGRATED NONLINEAR MICROWAVE AND MILLIMETRE-WAVE CIRCUITS, 2008. INMMIC 2008. WORKSHOP ON, IEEE, PISCATAWAY, NJ, USA, 24 novembre 2008 (2008-11-24), pages 75-78, XP031404867 ISBN: 978-1-4244-2645-4**
* **ANAKABE A ET AL: "Efficient nonlinear Stability Analysis of Microwave Circuits using Commercially Available Tools" EUROPEAN MICROWAVE CONFERENCE, 2002. 32ND, IEEE, PISCATAWAY, NJ, USA, 1 octobre 2002 (2002-10-01), pages 1-5, XP031068240**
* **BALSI M ET AL: "Discussion and new proofs of the conditional stability criteria for multidevice microwave amplifiers" IEE PROCEEDINGS: MICROWAVES, ANTENNAS AND PROPAGATION, IEE, STEVENAGE, HERTS, GB, vol. 153, no. 2, 3 avril 2006 (2006-04-03) , pages 177-181, XP006026317 ISSN: 1350-2417**

**EP 2 350 891 B1**

## Description

L'invention se rapporte à un procédé d'analyse automatique de stabilité de circuits électriques actifs, un système de mise en oeuvre du procédé avec un programme informatique et un tel programme informatique.

Afin d'éviter des oscillations indésirables dans des circuits à base de transistors et/ou diodes, par exemple des MMICs (dénomination anglaise de Micro-wave Monolithic Integrated Circuits, il est connu d'analyser la stabilité de tels circuits dits actifs en utilisant une technique fondée sur des procédés d'identification de système à partir de la réponse fréquentielle de circuits linéarisés autour d'un régime établi.

La réponse fréquentielle de circuits linéarisés autour d'un régime établi (en courant continu (DC) ou périodique) est obtenue à l'aide d'un outil logiciel de conception de circuit assisté par ordinateur (CAO) et par la mise en oeuvre des étapes consistant à :

- simuler le fonctionnement du circuit en état établi (DC ou périodique), définissant le point de fonctionnement du circuit dont sa stabilité doit être analysée, et

- faire varier en fréquence dans une bande de fréquence prédéterminée un signal de courant/tension injecté à un noeud/branche du circuit, ce signal représente l'entrée du circuit linearisé et il est qualifié de « faible signal » afin de ne pas changer l'état établi, et

- déterminer par l'outil de simulation, en sortie, la réponse du circuit à ce signal, une tension dans un noeud dans le cas d'une injection de signal de courant ou un courant dans une branche dans le cas d'une injection de signal de tension.

Ainsi, une réponse fréquentielle entrée/sortie correspondant à la linéarisation du circuit autour de son état établi est obtenue en tant qu'ensemble de modules et de phases de l'impédance ou de l'admittance de transfert du circuit en fonction de la fréquence.

A partir des valeurs de l'impédance ou de l'admittance de transfert, des procédés connus d'identification de fonctions de transfert utilisées en automatique comme modèle peuvent être mis en oeuvre en vue de l'étude de la stabilité électrique du circuit. Par exemple, l'outil logiciel Scilab permet une telle identification.

Le principe de découpage d'une bande d'analyse de stabilité en bandes de tailles plus petites sur lesquelles est effectuée l'analyse de stabilité de manière plus locale est également connu.

Pendant la mise en oeuvre du procédé d'identification à l'aide de l'outil logiciel Scilab, l'opérateur doit au préalable sélectionner un ordre de la fonction de transfert de modèle qu'il détermine de façon empirique par plusieurs essais en appréciant visuellement la qualité de l'identification.

L'absence de règles régissant la détermination d'une fonction de transfert d'identification comme étant la plus adaptée à l'analyse de stabilité entraîne une recherche de stabilité longue et fastidieuse et l'impossibilité d'automatiser une telle recherche.

Le problème technique est de déterminer un procédé structuré de recherche d'une fonction de transfert d'identification de modèle d'automatique, adaptée à l'analyse de stabilité du circuit, et entièrement automatique.

A cet effet, l'invention a pour objet un procédé d'analyse de stabilité électrique d'un circuit actif destiné à fonctionner dans un domaine de fréquences prédéterminé selon un régime linéaire ou non linéaire prédéterminé, comprenant des étapes consistant à :

partir d'un modèle physique fourni par un outil logiciel de type CAO du circuit, déterminer une réponse fréquentielle du circuit sous la forme d'une évolution de l'impédance de transfert I(f) ou de l'admittance de transfert A(f) du circuit en fonction de la fréquence, la fréquence décrivant une bande de fréquences discrète d'analyse et la réponse fréquentielle correspondant à la linéarisation du circuit autour de la solution en régime établi (DC, faible signal ou fort-signal),

enregistrer l'impédance ou l'admittance de transfert I(f) ou A(f) sous la forme d'une première fonction discrète du module (M) de l'impédance ou admittance en fonction de la fréquence d'analyse (f) et d'une deuxième fonction discrète de la phase ($\varphi$) de l'impédance ou admittance en fonction de la fréquence d'analyse (f),

diviser la bande d'analyse (B) en sous-bandes, chaque sous-bande entourant un extrémum local différent du module (M) de l'impédance ou admittance de transfert I(f) ou A(f),

ordonner l'ensemble de sous-bandes selon une séquence en affectant un rang à chaque sous-bande,

dans une étape d'identification élémentaire, pour une sous-bande ayant un rang fixé (rang_sb) et un ordre (n) de fonction de transfert prédéterminé :

identifier une fonction de transfert ($TFI_{ranf\_sb}$ (n)) ayant l'ordre prédéterminé (n) proche au sens d'une distance fonctionnelle de l'impédance ou admittance de transfert ($I_{rang\_sb}$ (f))restreinte à la sous-bande de rang fixé lorsque la fréquence décrit la sous-bande de rang fixé,

caractérisé en ce que :

pour une sous-bande ayant un rang fixé (rang_sb), le procédé comprend une étape de détermination automatique d'une fonction de transfert (($TFI_{ranf\_sb}$ (n_opti)) adaptée à l'analyse de stabilité, l'étape de détermination automatique étant exécutée sous la forme d'une boucle d'identification paramétrée selon un ordre de fonction de transfert courant croissant (n) et mettant en oeuvre l'étape d'identification élémentaire dans laquelle l'ordre prédéterminé est l'ordre de la fonction de transfert courant,

en ce que chaque étape d'identification élémentaire mise en oeuvre dans la boucle d'identification comprend une étape consistant à calculer une fonction d'erreur de phase err$\varphi$(n) comme étant l'ensemble des erreurs de phase décrit lorsque la fréquence décrit la sous-bande de rang fixé, l'erreur de phase à une fréquence donnée étant la différence entre la phase de la deuxième fonction et la phase de la fonction de transfert identifiée et à déterminer une norme de la fonction d'erreur, et en ce que le parcours de la boucle d'identification est arrêté lorsqu'une norme de la fonction d'erreur de phase a dépassé une valeur de seuil d'erreur de phase prédéterminée, et en ce qu'il comprend une étape consistant à déterminer la stabilité électrique du circuit à partir des positions des pôles et des zéros de la fonction de transfert identifiée à l'étape de détermination automatique.

Suivant des modes particuliers de réalisation, le procédé comporte l'une ou plusieurs des caractéristiques suivantes :

- une fonction de transfert d'identification d'ordre n est de rang pair et sa représentation de Laplace T(p) s'écrit sous la forme :

$$T(p) = \frac{a_n p^n + a_{n-1} p^{n-1} + \dots + a_1 p + a_0}{b_n p^n + b_{n-1} p^{n-1} + \dots + b_1 p + b_0}$$

dans laquelle $a_n$, $a_{n-1}$, ...$a_1$, $a_0$, $b_n$, $b_{n-1}$, ...$b_1$, $b_0$ désignent des coefficients réels et p désigne l'opérateur de Laplace de dérivation temporelle ;
- une fonction de transfert d'identification d'ordre n et de rang impair et sa représentation de Laplace T(p) s'écrit sous la forme :

$$T(p) = \frac{a_n p^n + a_{n-1} p^{n-1} + \dots + a_1 p + a_0}{b_{n-1} p^{n-1} + b_{n-2} p^{n-2} + \dots + b_1 p + b_0}$$

dans laquelle $a_n$, $a_{n-1}$, ...$a_1$, $a_0$, $b_{n-1}$, $b_{n-2}$, ...$b_1$, $b_0$ désignent des coefficients réels et p désigne l'opérateur de Laplace de dérivation temporelle ;
- la norme de la fonction d'erreur est la valeur absolue maximale de l'erreur de phase sur l'ensemble des erreurs de phase décrit lorsque la fréquence décrit la sous-bande de rang fixé ;
- la boucle est arrêtée lorsque la norme de la fonction d'erreur est inférieure à une valeur de seuil comprise entre 10$^{-5}$ et 10$^{-1}$, et de préférence égale à 0,001 ;

- le procédé comprend une boucle de limitation de l'ordre de la fonction de transfert déterminée automatiquement dans la boucle d'identification automatique lorsque l'ordre courant (n) dépasse une valeur prédéterminée (n_max), la boucle de limitation comportant les étapes consistant à :

interrompre la boucle d'identification automatique, découper la sous-bande de rang fixé en deux sous-bandes de plus petite taille, et mettre à jour la séquence d'ordonnancement de sous-bandes en affectant le rang déjà fixé à une première des sous-bandes obtenues par division et le rang déjà fixé incrémenté d'une unité à la deuxième des sous-bandes obtenues par division restante, et en décalant le rang des sous-bandes restantes dont le rang est supérieur au rang fixé d'une unité, et

- le procédé comprend une étape consistant à mettre en oeuvre la boucle d'identification pour la première sous-bande obtenue par division à l'étape de découpage de la sous-bande de rang fixé;
- le procédé comprend les étapes consistant à lorsque le critère d'arrêt fondé sur le franchissement de la valeur de seuil d'erreur de phase prédéterminé est satisfait, déterminer les pôles et les zéros complexes de la fonction de transfert identifiée automatiquement, et, dans une étape d'analyse d'une sous-bande affinée, lorsqu'il existe un pole et un zéro à partie réelle positive proche d'au moins une distance seuil dans le plan complexe prédéterminée, restreindre la sous-bande de rang fixé en cours d'analyse à une bande d'analyse affinée centrée sur l'extrémum local de la sous-bande en cours d'analyse et de largeur relative par rapport à la largeur de la sous-bande égale à une valeur prédéterminée ;
- dans l'étape d'analyse d'une sous-bande affinée, lorsqu'il existe un nombre de points de l'impédance ou admittance de transfert dans la sous-bande affinée au moins égal à une valeur prédéterminée, le rang fixé est affecté à la sous-bande affinée, et une boucle d'identification automatique du même type que la boucle d'identification décrite ci-dessus est mise en oeuvre dans la sous-bande affinée, puis les pôles et les zéros complexes de la fonction de transfert identifiée automatiquement dans la sous-bande affinée sont déterminés, et il est vérifié s'il existe toujours une instabilité ;
- dans l'étape d'analyse d'une sous-bande affinée, lorsque le nombre de points dans la sous-bande affinée est inférieur ou égale à la valeur prédéterminée alors cette bande est étendue jusqu'à ce que son nombre de points soit égal à la valeur prédéterminée ; et

- il comprend une boucle dans laquelle les sous-bandes sont balayées en faisant varier le rang affecté à chacune d'entre elles et la stabilité électrique dans chaque sous-bande est analysée.

L'invention a également pour objet un procédé de fabrication d'un circuit électrique comprenant les étapes consistant à
concevoir mécaniquement et électriquement un circuit électrique et le représenter par un modèle physique,
valider la stabilité électrique du circuit par le procédé tel que défini ci-dessus,
réaliser le circuit électrique ayant les caractéristiques de stabilité électrique déterminées dans le procédé d'analyse défini tel que défini ci-dessus.

L'invention a également pour objet un produit programme d'ordinateur comprenant des instructions de programme pour mettre en oeuvre les étapes de procédé tel que défini ci-dessus lorsque ledit programme fonctionne sur un ordinateur.

L'invention a également pour objet un outil d'analyse de stabilité électrique d'un circuit actif destiné à fonctionner dans un domaine de fréquences prédéterminé selon un régime linéaire ou non linéaire prédéterminé, comprenant :

un outil logiciel de type CAO du circuit, apte à déterminer, à partir d'un modèle physique, une réponse fréquentielle du circuit sous la forme d'une évolution de l'impédance ou admittance de transfert I(f) ou A(f) du circuit en fonction de la fréquence, la fréquence décrivant une bande de fréquences discrète d'analyse et la réponse fréquentielle correspondant à la linéarisation du circuit autour de la solution de l'état établi,
une mémoire pour enregistrer l'impédance de transfert I(f) ou admittance de transfert A(f) sous la forme d'une première fonction discrète du module (M) de l'impédance en fonction de la fréquence d'analyse (f) et d'une deuxième fonction discrète de la phase ($\varphi$) de l'impédance en fonction de la fréquence d'analyse (f),
un moyen de division de la bande d'analyse (B) en sous-bandes, chaque sous-bande entourant un extrémum local différent du module (M) de l'impédance ou admittance de transfert I(f) ou A(f),
un moyen d'ordonnancement de l'ensemble de sous-bandes selon une séquence en affectant un rang à chaque sous-bande,
un moyen d'identification élémentaire apte à, pour une sous-bande ayant un rang fixé (rang_sb) et un ordre (n) de fonction de transfert prédéterminé identifier une fonction de transfert ($TFI_{ranf\_sb}$ (n)) ayant l'ordre prédéterminé (n) proche au sens d'une distance fonctionnelle de l'impédance ou admittance de transfert ($I_{rang\_sb}$ (f)) restreinte à la sous-bande de rang fixé lorsque la fréquence décrit la sous-bande de rang fixé,

caractérisé en ce qu'il comprend :

un moyen de détermination automatique (22) d'une fonction de transfert (($TFI_{ranf\_sb}$ (n_opti)) adaptée à l'analyse de stabilité, pour une sous-bande ayant un rang fixé (rang_sb) apte à exécuter une boucle d'identification (24) paramétrée selon un ordre de fonction de transfert courant croissant (n) et à activer le moyen d'identification élémentaire en lui fournissant l'ordre de la fonction de transfert courant comme ordre prédéterminé,
le moyen d'identification élémentaire étant apte à calculer une fonction d'erreur de phase $err_\varphi(n)$ comme étant l'ensemble des erreurs de phase décrit lorsque la fréquence décrit la sous-bande de rang fixé, l'erreur de phase à une fréquence donnée étant la différence entre la phase de la deuxième fonction et la phase de la fonction de transfert identifiée et à déterminer une norme de la fonction d'erreur, et en ce que
le moyen de détermination automatique est apte à arrêter la boucle d'identification automatique lorsque la norme de la fonction d'erreur de phase a dépassé une valeur de seuil d'erreur de phase prédéterminée, et en ce qu'il comprend un moyen de détermination de la stabilité électrique du circuit à partir des positions des pôles et des zéros de la fonction de transfert identifiée à l'étape de détermination automatique.

L'invention sera mieux comprise à la lecture de la description d'une unique forme de réalisation qui va suivre, donnée uniquement à titre d'exemple et faite en se référant aux dessins sur lesquels :

- la Figure 1 est un ordinogramme du procédé de l'invention,
- la Figure 2 est un bloc fonctionnel d'un circuit actif fonctionnant en mode de linéarisation autour de la solution faible signal en régime établi,
- la Figure 3 une vue d'un tracé de l'évolution en fonction de la fréquence du module d'une impédance de transfert simulée et observée dans une bande de fréquences d'analyse avec un découpage en trois sous-bandes,
- la Figure 4 est une vue d'un tracé de l'évolution en fonction de la fréquence du module des trois fonctions d'identification avec un ordre respectif correspondant chacune à l'impédance de transfert restreinte à une sous-bande correspondante de la figure 3, la fonction d'identification étant obtenue à l'étape d'identification automatique 22 du procédé de la figure 1,
- la Figure 5 est une vue d'un tracé de l'évolution en fonction de la fréquence de la phase des trois fonctions d'identification avec un ordre respectif correspondant chacune à l'impédance de transfert restreinte à la sous-bande correspondante de la figure 3, la fonction d'identification étant obtenue à l'étape d'identification automatique du procédé décrit à la figure 1,

- la Figure 6 est une vue des écarts de phase entre les phases de la fonction d'identification obtenu à l'étape d'identification automatique et les phases des points de simulation de l'impédance de transfert restreinte successivement à la première, la deuxième et troisième sous-bandes,

- la Figure 7 est une représentation dans le plan complexe des pôles et des zéros des fonctions d'identification illustrés aux figures 4 et 5,.

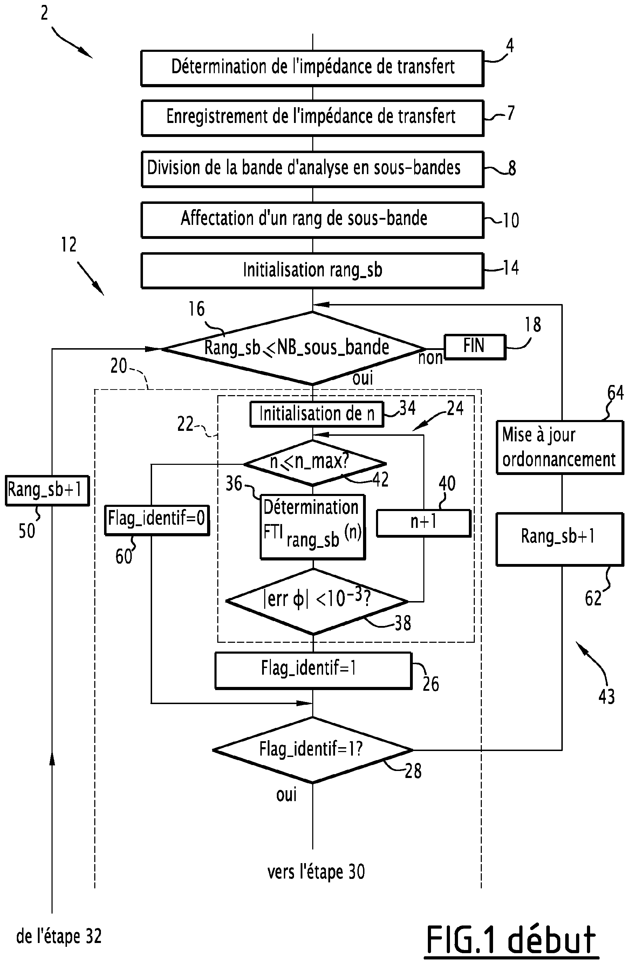

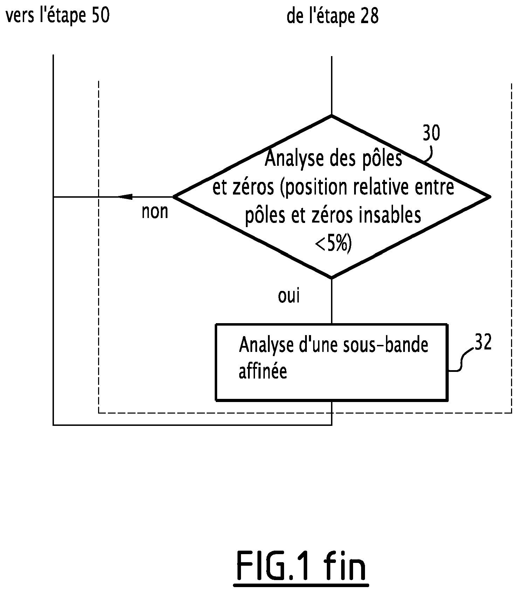

Suivant la figure 1, un procédé d'analyse 2 de stabilité électrique d'un circuit actif fonctionnant dans un domaine de fréquences selon un régime non linéaire prédéterminé comprend un ensemble d'étapes avec différentes boucles.

Un circuit actif typique est par exemple un MMIC comprenant des circuits à base de transistors intégrés sur un ou plusieurs substrats, le tout étant enfermé sous vide et de manière étanche dans un boitier métallique.

Dans une première étape 4, la réponse fréquentielle du circuit actif est déterminée par simulation à l'aide d'un outil logiciel de type CAO (Conception Assistée par Ordinateur) comme par exemple un outil (le simulateur électrique ADS d'Agilent) utilisant une modélisation de type SPICE (Tajima, Curtis, TOM etc...) des composants élémentaires du circuit.

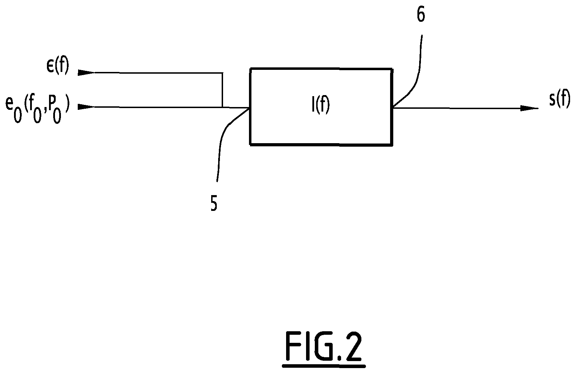

Suivant la figure 2, la réponse fréquentielle en mode de linéarisation autour d'un point de fonctionnement en état établi est représentée sous la forme de l'évolution de l'impédance I(f) ou l'admittance A(f) de transfert du circuit en fonction de la fréquence de balayage f d'un faible signal $\varepsilon$(f).

L'impédance ou admittance de transfert, I(f) ou A(f), du circuit correspond à une borne d'entrée 5 et une borne de sortie 6 du circuit prédéterminées.

Le circuit fonctionne ici à une fréquence de régime non linéaire établi $f_0$ et une puissance électrique de sortie $P_0$ prédéterminées, définissant un point de fonctionnement du circuit, par l'injection à la borne d'entrée 5 d'un premier signal d'amplitude prédéterminée $e_0$ ($f_0$, $P_0$).

Le faible signal $\varepsilon$(f) associé à une fréquence de balayage $\underline{f}$ constituant un deuxième signal est injecté également à la borne d'entrée 5 du circuit et superposé au premier signal $e_0$ ($f_0$, $P_0$), le deuxième signal étant qualifié de « faible signal » en raison de sa faible amplitude par rapport à celle du premier signal, par exemple en dessous de 40 dB par rapport à l'amplitude du premier signal $e_0$ ($f_0$, $P_0$). Il est à remarquer que pour les analyses fort signal, certains simulateurs disposent d'un mode dit mélangeur ('mixer mode') permettant par principe d'extraire la linéarisation du circuit sans avoir à spécifier de façon adéquate le niveau du générateur « faible signal » (obtention des matrices de conversion). A défaut, l'utilisateur devra régler de façon adéquate le niveau de la perturbation.

Le signal de sortie à la fréquence de balayage f, noté s(f) et présent à la borne de sortie 6, est déterminé par simulation.

L'impédance de transfert I(f) ou l'admittance de transfert A(f) est définie comme étant égale à s(f)/ $\varepsilon$(f).

La fréquence de balayage f du faible signal $\varepsilon$(f) varie dans une bande de fréquences prédéterminée par incrément, la fréquence de balayage étant différente d'un harmonique ou d'un sous-harmonique à un ordre quelconque de la fréquence $f_0$ du premier signal $e_0$ ($f_0$, $P_0$).

La fréquence de balayage décrit ainsi de manière discrète une bande de fréquences discrètes d'analyse B et la réponse fréquentielle mesurée correspond à la linéarisation du circuit autour de la solution faible signal d'un régime établi non-linéaire.

En variante, le premier signal est un signal occupant une bande étroite par rapport à la bande passante du circuit.

En variante, l'impédance de transfert, respectivement l'admittance de transfert est une impédance, respectivement une admittance de transfert mesurée.

Dans une étape suivante 7, l'impédance ou l'admittance de transfert simulée correspondant à un modèle physique est enregistrée sous la forme d'une première fonction discrète et d'une deuxième fonction discrète.

La première fonction représente le module M(f) de l'impédance I(f) ou admittance A(f) de transfert, en fonction de la fréquence de balayage f, formant la bande d'analyse B.

La deuxième fonction représente la phase $\varphi$(f) de l'impédance I(f) ou admittance A(f) de transfert en fonction des mêmes fréquences f de balayage que pour le module M(f).

Puis, dans une étape 8, la bande d'analyse B est divisée en sous-bandes, chaque sous-bande entourant un extrémum local différent du module M de l'impédance ou admittance de transfert $I_{rang\_sb}$ (f) restreinte à la sous-bande de rang rang_sb.

Les changements de sens de pente de la première fonction M(f) sont détectés par une méthode quelconque d'analyse numérique classique.

Des indices $\underline{i}$ des fréquences de balayage ordonnés selon un ordre croissant correspondant aux changements de pente sont enregistrés dans une liste avec un premier et un dernier indice.

Un vecteur qualifié de découpe $\underline{V}$ est créé qui regroupe les indices de changement de sens de pente ainsi que leurs milieux hormis les milieux correspondant aux premier et dernier indices.

Les sous-bandes $SB_i$ sont déterminées comme étant chaque portion de bande délimitée par deux milieux successifs et le nombre total de sous-bandes déterminées est affecté à un paramètre référencé NB_sous_bande.

Dans une étape suivante 10, un rang entier distinct rang_sb est affecté à chaque sous-bande et les sous-bandes sont ainsi ordonnées selon un ordre de sous-bande croissant.

Puis, une première boucle 12 de parcours des sous-bandes à analyser est initialisée dans une étape d'initialisation 14.

Le paramètre courant de parcours de la première boucle est le rang de sous-bande. Il est référencé rang_sb et il est mis à la valeur de l'entier un dans l'étape d'initialisation 14.

Dans une étape de branchement 16 de la première boucle 12, un test de comparaison de la valeur courante du paramètre de parcours rang_sb de la première boucle est effectué.

Suivant ce test, si le paramètre de rang de sous-bande courant rang_sb est supérieur à la valeur du nombre total de sous-bandes NB_sous_bande, alors le procédé d'analyse de stabilité 2 est terminé par une étape de fin de procédé 18.

A l'inverse, le procédé 2 continue pour exécuter une étape 20 d'analyse de stabilité électrique du circuit dans la sous-bande de fréquence correspondant au rang de sous-bande courant rang_sb.

L'étape d'analyse 20 comprend une étape de détermination automatique 22 d'une fonction de transfert d'identification $FTI_{rang\_sb}$ (n_opti), d'un type adapté une modélisation en automatique, et adaptée à l'analyse de stabilité de l'impédance ou admittance de transfert $I_{rang\_sb}$ (f) restreinte à la sous-bande de fréquence correspondant au rang de sous-bande courant rang_sb.

L'étape de détermination automatique 22 est réalisée sous la forme d'une deuxième boucle 24 paramétrée selon un deuxième paramètre courant de boucle formé par un ordre référence $\underline{n}$ d'une fonction de transfert d'identification $FTI_{rang\_sb}$ (n).

L'ordre $\underline{n}$ correspond ici au degré de la représentation de Laplace T(p) de la fonction de transfert d'identification dont la forme paire est choisie de sorte que la représentation s'écrit :

$$T(p) = \frac{a_n p^n + a_{n-1} p^{n-1} + ... + a_1 p + a_0}{b_n p^n + b_{n-1} p^{n-1} + ... + b_1 p + b_0}$$

dans laquelle $a_n$, $a_{n-1}$, ...$a_1$, $a_0$, $b_n$, $b_{n-1}$, ...$b_1$, $b_0$ désignent des coefficients réels et $p^k$ désigne l'opérateur de Laplace de dérivation temporelle d'ordre k.

De manière équivalente, la fonction de transfert d'identification représentée dans la représentation de Fourier s'écrit T(jω) avec ω la pulsation égale à 2.π.f où f désigne la fréquence.

En variante, une forme impaire de la fonction de transfert d'ordre $\underline{n}$ est choisie et sa représentation de Laplace d'écrit :

$$T(p) = \frac{a_n p^n + a_{n-1} p^{n-1} + ... + a_1 p + a_0}{b_{n-1} p^{n-1} + b_{n-2} p^{n-2} + ... + b_1 p + b_0}$$

dans laquelle $a_n$, $a_{n-1}$, ...$a_1$, $a_0$, $b_{n-1}$, $b_{n-2}$, ...$b_1$, $b_0$ désignent des coefficients réels et p désigne l'opérateur de Laplace de dérivation temporelle.

L'étape d'analyse 20 comprend également une étape de chargement d'état 26 dans un indicateur de sortie de la deuxième boucle 24 référencé flag_identif, une étape de branchement et de vérification 28 de l'indicateur de sortie de la deuxième boucle 24, une étape d'analyse de pôles et de zéros 30 de la fonction de transfert $FTI_{rang\_sb}$ (n_opti) de sortie de la boucle 24, une étape d'affinement 32 de l'analyse de la stabilité de la fonction de transfert identifiée FTI-rang_sb (n_opti) associée à l'impédance ou admittance de transfert restreinte à la sous-bande de rang rang_sb.

La deuxième boucle 24 ou boucle d'identification comprend une étape d'initialisation 34 de l'ordre $\underline{n}$, une étape d'identification élémentaire 36 de la fonction de transfert d'ordre $\underline{n}$, $FTI_{rang\_sb}$ (n) associée à l'impédance ou admittance de transfert restreinte à la sous-bande de rang rang_sb, une étape 38 de branchement principal avec un critère d'arrêt principal de la deuxième boucle 24, une étape d'incrémentation 40 de l'ordre $\underline{n}$ de la fonction de transfert d'identification $FTI_{rang\_sb}$ (n) et une étape de limitation 42 ou de branchement auxiliaire à une troisième boucle 43 appelée boucle de limitation avec un critère de limitation directe de l'ordre $\underline{n}$ de la deuxième boucle 24, l'étape 42 étant a interposée entre l'étape 34 et l'étape 36.

Dans l'étape d'initialisation 34, la valeur de l'ordre courant $\underline{n}$ est mise à une valeur comprise entre 1 et 20. Ici, de manière préférée la valeur de l'ordre courant $\underline{n}$ est mise à une valeur égale à 3.

Puis dans l'étape 42, il est vérifié si l'ordre courant $\underline{n}$ est inférieur ou égal à une valeur d'ordre maximal prédéterminée référencée n_max, ici égale à 20.

La valeur d'ordre maximal n_max est comprise entre 1 et 100, de préférence entre 15 et 30, et est égale ici à 20.

Dans le cas où l'ordre courant $\underline{n}$ est inférieur ou égal à une valeur d'ordre maximale, alors le procédé 2 est poursuivi à l'étape 36.

Dans l'étape d'identification élémentaire 36, le rang de la sous-bande et l'ordre de la fonction de transfert étant fixés respectivement par le premier paramètre courant rang_sb de la première boucle 12 et le deuxième paramètre courant $\underline{n}$ de la deuxième boucle 24, la fonction de transfert d'identification d'ordre $\underline{n}$ FTI-rang_sb (n) est déterminée en ajustant les coefficients de sorte que la fonction de transfert d'identification $FTI_{rang\_sb}$ (n) approche au plus près de l'impédance ou admittance de transfert $I_{rang\_sb}$ (f) restreinte à la sous-bande d'analyse de rang de sous-bande courant rang_sb.

Pour définir la proximité de la fonction de transfert d'identification d'ordre $\underline{n}$ FTI$_{rang\_sb}$ (n) par rapport à l'impédance ou admittance de transfert I$_{rang\_sb}$ (f) restreinte à la sous-bande d'analyse de rang de sous-bande courant rang_sb, une distance fonctionnelle est définie entre ladite fonction de transfert et ladite impédance ou admittance de transfert.

La distance est définie classiquement comme une distance entre deux vecteurs dont les composantes sont des nombres complexes, un premier vecteur correspondant à la fonction de transfert d'ordre $\underline{n}$ FTI$_{rang\_sb}$ (n) et un deuxième vecteur correspondant à l'impédance transfert I$_{rang\_sb}$ (f).

L'outil Scilab met en oeuvre un algorithme connu fondé sur la méthode des moindres carrés permettant d'obtenir de cette manière une fonction de transfert d'identification.

Dans l'étape 36, la fonction de transfert d'ordre $\underline{n}$ FTI$_{rang\_sb}$ (n) à valeurs complexes identifiée est décomposée en son module formant une première composante C1 (n,f) et sa phase formant une deuxième composante C2(n,f).

Puis, dans la même étape 36, une fonction d'erreur de phase err$_\varphi$(n) est calculée comme étant l'ensemble des erreurs de phase décrit lorsque la fréquence décrit la sous-bande de rang fixé rang_sb, l'erreur de phase à une fréquence donnée étant la différence entre la phase de la deuxième fonction $\varphi$(f) de l'impédance ou admittance de transfert I$_{rang\_sb}$ (f) restreinte à la sous-bande de rang de sous-bande rang_sb et la phase C2(n,f) de la fonction de transfert d'ordre $\underline{n}$ courant identifiée FTI$_{rang\_sb}$ (n).

Ensuite, dans la même étape 36, une norme de la fonction d'erreur de phase err$_\varphi$(n) est calculée.

Par exemple, la norme de la fonction d'erreur de phase est la valeur absolue maximale d'erreur de phase décrite sur l'ensemble des erreurs de phase de la fonction d'erreur de phase err$_\varphi$(n) lorsque la fréquence f décrit la sous-bande de rang courant rang_sb.

En variante, la norme de la fonction d'erreur de phase err$_\varphi$(n) est une norme quadratique égale à la racine carrée de la somme quadratique des erreurs de phase décrite sur l'ensemble des erreurs de phase de la fonction d'erreur de phase err$_\varphi$(n) lorsque la fréquence décrit la sous-bande de rang courant rang_sb.

Dans l'étape 38, la norme de la fonction d'erreur de phase err$_\varphi$(n) est comparée à une valeur de seuil d'erreur de phase prédéterminée, cette comparaison constituant le critère d'arrêt principal et de sortie de la deuxième boucle 24.

La valeur de seuil d'erreur de phase est comprise entre $10^{-8}$ et 10, de préférence entre $10^{-5}$ et $10^{-1}$ ,et est ici égale à 0,001.

Si la norme de la fonction d'erreur de phase err$_\varphi$(n) est supérieure ou égale à la valeur de seuil d'erreur de phase prédéterminée, alors l'ordre courant $\underline{n}$ de la fonction de transfert d'identification FTI$_{rang\_sb}$ (n) est augmenté d'une unité à l'étape d'incrémentation 40 et le parcours de la deuxième boucle 24 continue jusqu'à l'étape 42 avec l'ordre courant $\underline{n}$ résultant de l'incrémentation 40.

A l'inverse, si la norme de la fonction d'erreur de phase est inférieure à la valeur de seuil d'erreur de phase prédéterminée, alors le parcours à l'intérieur de la deuxième boucle 24 est arrêté et l'indicateur d'état de sortie flag_identif de la deuxième boucle 24 est mis à 1 pour indiquer que l'état de sortie de la deuxième boucle 24 est celui correspondant à la satisfaction du critère d'arrêt principal de la deuxième boucle 24, à savoir que la norme de la fonction d'erreur de phase est passée en dessous la valeur du seuil d'erreur de phase prédéterminé. Dans ce cas, l'étape 20 se poursuit à l'étape de branchement et de vérification 28 de l'indicateur de sortie flag_identif de la deuxième boucle 24.

Dans l'étape d'aiguillage 28, si l'indicateur de sortie flag_identif de la deuxième boucle 24 est égal à un, alors l'étape d'analyse des pôles et des zéros 30 est mise en oeuvre.

Au cours de l'étape 30, les pôles et les zéros complexes de la fonction de transfert identifiée ayant un ordre référencé n_opti sont déterminés par une méthode de calcul classique. L'ordre référencé n_opti correspond à l'ordre courant $\underline{n}$ existant à la sortie de l'étape 38.

Les pôles et les zéros sont des nombres complexes dont les parties réelles et les parties imaginaires sont les coordonnées de vecteurs associés dans le plan complexe.

Les parties réelles et les parties imaginaires sont des grandeurs fréquentielles.

Puis, au cours de la même étape 30, les positions respectives des pôles et des zéros déterminés dans le plan complexe sont analysées.

Lorsqu'il n'existe pas de pôle et de zéro à partie réelle positive distants dans le plan complexe d'une distance relative inférieure ou égale à une distance relative de seuil prédéterminée, alors il est décidé que le circuit est stable électriquement dans la sous-bande de rang courant rang_sb de la première boucle 12.

La distance relative d'un pôle par rapport à un zéro est ici définie comme étant le rapport de la distance euclidienne dans le plan complexe entre le pôle et le zéro sur le rayon vecteur du pôle ou du zéro par rapport à l'origine du plan complexe.

Lorsqu'il n'existe pas de pôle et de zéro à partie réelle positive distants dans le plan complexe d'une distance relative inférieure ou égale à une distance relative de seuil prédéterminée, le paramètre de parcours rang_sb de la première boucle 12 est incrémenté d'une unité dans une étape 50 et le procédé d'analyse de stabilité 2 du circuit est alors poursuivi dans la sous-bande d'analyse suivante par le branchement à l'étape 16 avec la valeur rang_sb incrémentée.

La valeur de la distance relative de seuil est comprise entre 0,1% et 100%, de préférence comprise entre 1 % et 5%, est ici égale à 3%.

Lorsqu'il existe un pôle et un zéro à partie réelle positive distants dans le plan complexe d'une distance relative inférieure ou égale à la distance relative de seuil prédéterminée, alors dans l'étape d'affinement 32, la sous-bande de rang courant en cours d'analyse rang_sb est restreinte à une sous-bande d'analyse affinée ou plus étroite, centrée sur l'extrémum local de la sous-bande en cours d'analyse de rang courant rang_sb. La largeur relative de la sous-bande affinée par rapport à la largeur de la sous-bande en cours d'analyse est comprise entre 0,1 % et 100%, de préférence entre 1 % et 5%, et est ici égale à 3%.

Lorsqu'il existe un nombre de points de l'impédance ou admittance de transfert dans la sous-bande affinée au moins égal à une valeur prédéterminée de nombre minimal de points comprise entre 1 et 500, de préférence comprise entre 10 et 20, ici égale à 15, dans l'étape 32, le sous_rang courant fixé rang_sb est affecté à la sous-bande affinée, une boucle d'identification automatique du même type que la boucle 24 est mise en oeuvre dans la sous-bande affinée, puis les pôles et les zéros complexes de la fonction de transfert identifiée automatiquement dans la sous-bande affinée sont déterminés de manière similaire à l'étape 32 pour vérifier s'il existe toujours une instabilité,

Lorsque le nombre de points dans la sous-bande affinée est inférieur ou égale à la valeur prédéterminée du nombre minimal de points, alors il est déterminé dans l'étape 32 s'il existe une instabilité électrique.

Puis, le paramètre de parcours rang_sb de la première boucle 12 est incrémenté d'une unité dans l'étape d'incrémentation 50 et le procédé d'analyse du circuit est alors poursuivi dans la sous-bande d'analyse suivante par le branchement à l'étape 16 avec la valeur rang_sb incrémentée.

Dans le cas où l'ordre courant $\underline{n}$ est vérifié dans l'étape de limitation 42 comme étant supérieur à la valeur d'ordre maximale n_max, alors un branchement est effectué sur la troisième boucle 43 de limitation directe de l'ordre $\underline{n}$ recherché dans la deuxième boucle 24.

La troisième boucle 43 comprend exécutées successivement, l'étape de limitation 42, une étape de chargement à zéro 60 de l'indicateur de sortie flag_identif de la deuxième boucle 24, l'étape d'aiguillage 28, une étape de découpage en deux 62 de la sous-bande de rang courant, une étape de mise à jour 64 de la séquence d'ordonnancement de sous-bandes et l'étape 16.

L'étape de limitation 42 de l'ordre de la fonction de transfert déterminée automatiquement interrompt la deuxième boucle 24 lorsque l'ordre courant $\underline{n}$ dépasse la valeur d'ordre maximal n_max.

Puis, dans l'étape 60, l'indicateur de sortie flag_identif de la deuxième boucle 24 est mis à zéro.

Puis dans l'étape d'aiguillage 28, il est vérifié l'état de flag_identif. Lorsqu'il est à zéro, l'étape d'aiguillage 28 branche le procédé 2 à l'étape de découpage 62 de la sous-bande de rang courant rang_sb en deux sous-bandes adjacentes de taille plus petite.

Puis dans l'étape 64, la séquence d'ordonnancement des sous-bandes est mise à jour en affectant le rang courant rang_sb à une première sous-bande obtenue par division à l'étape 62 et le rang courant incrémenté d'une unité à la deuxième sous-bande obtenue par division, et en décalant d'une unité le rang des sous-bandes restantes dont le rang est strictement supérieur au rang courant rang_sb plus une unité.

Ensuite, la deuxième boucle 24 est à nouveau mise en oeuvre par le branchement à l'étape 16.

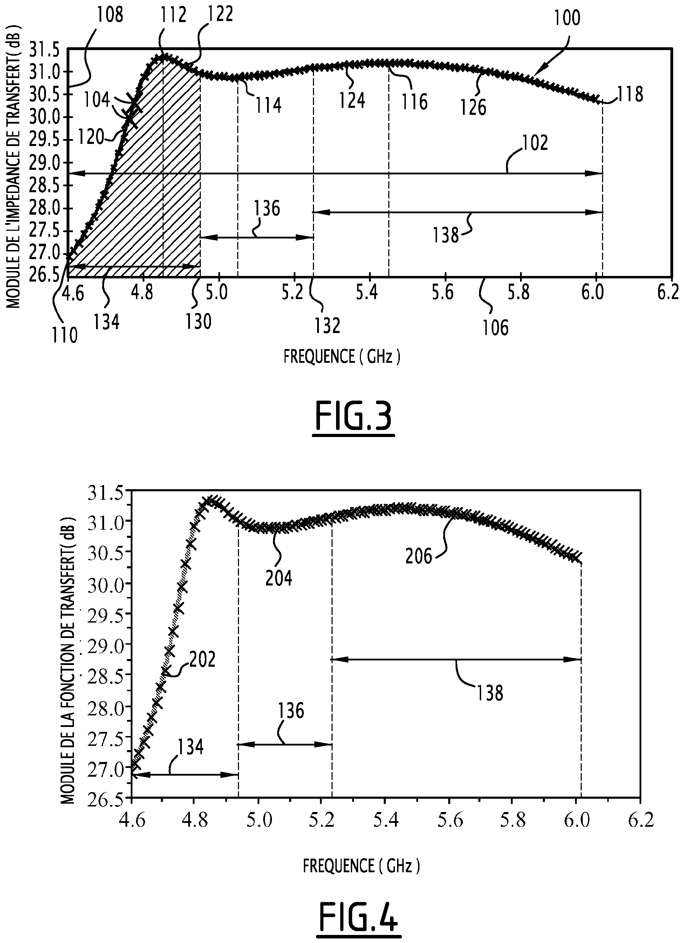

Suivant la figure 3, le module de l'impédance ou admittance de transfert 100 simulée et observée dans une bande de fréquences d'analyse 102 comprend une suite de points 104 représentés par des croix et repérés par une abscisse selon un axe des fréquences 106 exprimés en GHz, et une ordonnée selon un axe de gain 108 entre une entrée et une sortie exprimé en dB.

Le module de l'impédance ou admittance de transfert est interpolé par une fonction d'interpolation de lissage entre les différents points 104.

Le module de l'impédance ou admittance de transfert 100 comprend des extrema locaux avec un point initial 110, un premier maximum local 112 suivi d'un minimum local 114, puis un deuxième maximum local 116 et un point final 118.

Le module de l'impédance ou admittance de transfert 100 comprend quatre tronçons successifs 120, 122, 124, 126 ayant des pentes de signe opposé. Le premier tronçon 120 et le troisième tronçon 124 ont une pente positive tandis que les deuxième 122 et quatrième 126 ont une pente négative.

Deux milieux sont déterminés, un premier milieu 130 d'un premier segment de fréquences délimité par les abscisses correspondant au premier maximum local 112 et le minimum local 114, et un deuxième milieu 132 d'un deuxième segment de fréquences délimité par les abscisses correspondant au minimum local 114 et au deuxième maximum local 116.

Une première sous-bande 134 est déterminée comme étant le segment de fréquences délimité par l'abscisse du point initial 110 et le premier milieu 130.

Une deuxième sous-bande 136 est déterminée comme étant le segment de fréquences délimité par le premier milieu 130 et le deuxième milieu 132.

Une troisième sous-bande 138 est déterminée comme étant le segment de fréquences délimité par le deuxième milieu 132 et l'abscisse du point final 118.

Les sous-bandes 134, 136, 138 sont déterminées au cours de l'étape 8.

Au cours de l'étape 10, des rangs de sous-bande différents 1, 2 et 3 sont affectés respectivement aux sous-bandes 134, 136 et 138.

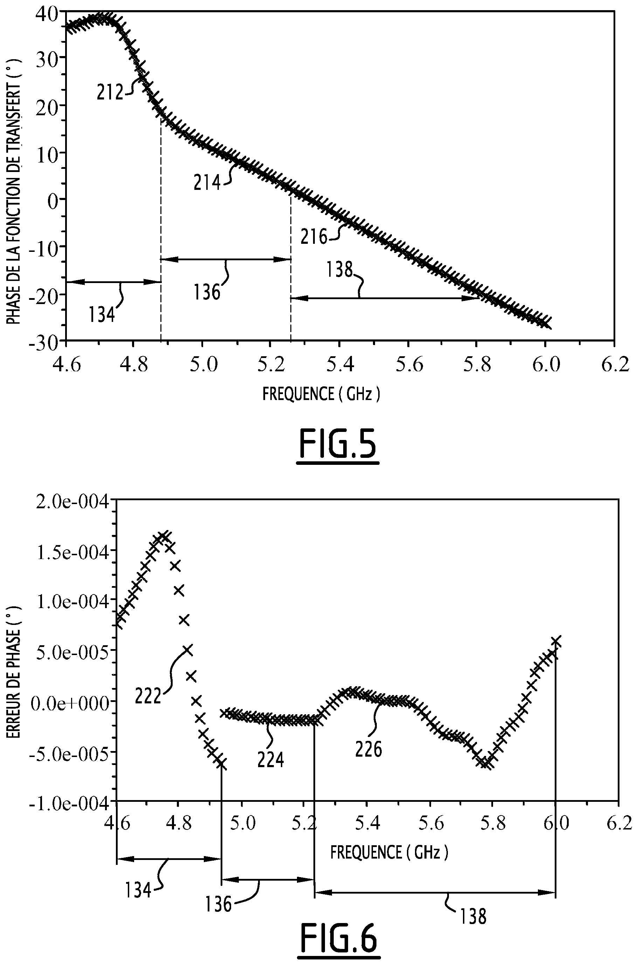

Suivant la figure 4, respectivement la figure 5 sont représentés par des croix les modules, respectivement les phases de l'impédance ou admittance de transfert successivement restreinte aux première, deuxième, troisième sous-bandes 134, 136, 138 décrites à la figure 3.

Suivant la figure 4, trois courbes de module 202, 204, 206 en traits ininterrompus représentent les modules de trois fonctions de transfert distinctes identifiées successivement dans l'étape d'identification automatique 22 et correspondant chacune à l'identification de l'impédance ou admittance de transfert restreinte respectivement à chaque sous-bande 134, 136, 138.

L'axe des abscisses est l'axe des fréquences gradué en GHz tandis que l'axe des ordonnés est l'axe des modules gradé en dB.

Suivant la figure 5, trois courbes de phase 212, 214, 216 en traits ininterrompus représentent les phases des trois fonctions de transfert distinctes identifiées successivement dans l'étape d'identification automatique 22 et correspondant chacune à l'identification de l'impédance ou admittance de transfert restreinte respectivement à chaque sous-bande 134, 136, 138, et correspondant également aux courbes 202, 204, 206.

L'axe des abscisses est l'axe des fréquences gradué en GHz tandis que l'axe des ordonnés est l'axe des phases gradué en degrés.

Suivant la figure 6, trois courbes d'erreur de phase 222, 224, 226, formées chacune par une suite de points, représentent les écarts de phase entre les phases décrites à la figure 5 des trois fonctions de transfert distinctes identifiées successivement dans l'étape d'identification automatique 22 et les phases correspondantes de l'impédance ou admittance de transfert, lorsqu'elles ont été simulées, représentées par des croix sur la figure 5.

Les trois courbes 222, 224, 226 correspondent chacune à une seule sous-bande 134, 136, 138.

L'axe des abscisses est l'axe des fréquences gradué en GHz tandis que l'axe des ordonnés est l'axe des erreurs de phase gradué en unité égale à 0,5 fois $10^{-5}$ degrés.

Il est à remarquer que sur la figure 5, cet écart n'est pas visible en raison de l'échelle de l'axe des ordonnés qui est nettement plus grande que celle de la figure 6 qui représente une vue détaillée agrandie des variations de phase dont l'ordre de grandeur est inférieure à quelques dix millièmes de degrés.

Suivant la figure 6, considérant une norme de la fonction d'erreur de phase définie comme étant le maximum sur l'ensemble d'une sous-bande des valeurs absolues des écarts de phases et considérant une valeur de seuil de sortie de la boucle 24 égale à 0,001, il apparaît bien que la norme de la fonction d'erreur de phase pour chaque sous-bande 134, 136, 138 est inférieure à la valeur de seuil de seuil de sortie de la boucle 24 et que l'ordre n_opti correspondant de chaque fonction de transfert identifié sur la sous-bande associé permet de satisfaire le critère de sortie principal de la boucle 24.

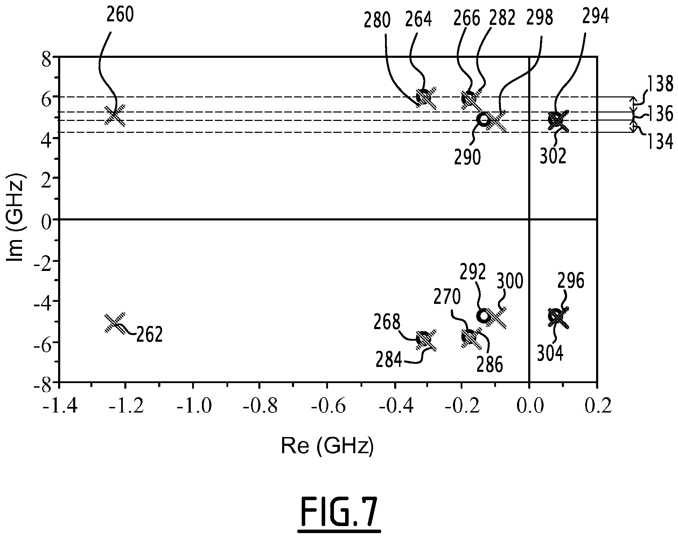

Suivant la figure 7, les pôles et les zéros des trois fonctions de transfert identifiées et décrites aux figures 4 et 5 sont représentés respectivement par des croix et des cercles.

Un découpage des sous-bandes 134, 136, 138 sur le demi-plan complexe des ordonnées positives selon l'axe Im, est représenté par des bandes parallèles à l'axe des abscisses Re.

L'axe des abscisses est un axe fréquentiel gradué en unités égales chacune à 0,1 GHz et l'axe des ordonnées est un axe fréquentiel gradué unitairement en GHz.

Un premier pôle 260 et un deuxième pole 262 symétrique par rapport à l'axe Re correspondent à la fonction de transfert identifiée pour la deuxième sous-bande 136.

Des premier, deuxième, troisième, quatrième zéros référencés respectivement 264, 266, 268, 270 correspondent à la fonction de transfert identifiée pour la troisième sous-bande 138.

Des troisième, quatrième, cinquième, sixième pôles référencés respectivement 280, 282, 284, 286 correspondent à la fonction de transfert identifiée pour la troisième sous-bande 138.

Des cinquième, sixième, septième, huitième zéros référencés respectivement 290, 292, 294, 296 correspondent à la fonction de transfert identifiée pour la première sous-bande 134.

Des septième, huitième, neuvième, dixième pôles référencés respectivement 298, 300, 302, 304 correspondent à la fonction de transfert identifiée pour la première sous-bande 134.

Les parties réelles des pôles 260, 262 étant négatives, le circuit électrique est déterminé à l'étape 30 comme étant stable dans la deuxième sous-bande 136.

Les parties réelles des zéros 264, 266, 268, 270 et les parties réelles des pôles 280, 282, 284, 286 étant négatives, le circuit électrique est déterminé à l'étape 30 comme étant stable dans la troisième sous-bande 138.

Il existe des couples de zéro et pôle, 294 et 302, 296 et 304, dont les parties réelles sont positives, et pour lesquels la distance relative entre un zéro et un pôle apparié est inférieure égale à 5%, valeur considérée ici la valeur de distance relative de seuil. Dans l'étape 30, il est décidé de mettre en oeuvre l'étape d'analyse 32 sur une bande affinée et dans cet exemple il est confirmé la présence de couples pôle/zéro instables pour la fréquence de 4,8 GHz.

Un outil de mise en oeuvre du procédé 2 comprend un moyen de simulation de l'impédance ou admittance de transfert I(f) ou A(f) à partir de schémas électriques et de plans mécaniques du circuit, un mémoire d'enregistrement de l'impédance ou admittance de transfert I(f) ou A(f), un moyen de division de la bande d'analyse en sous-bandes, un moyen d'identification élémentaire d'une fonction de transfert élémentaire à partir d'une sous-bande, d'un ordre prédéterminé et de l'impédance ou admittance de transfert, un moyen de détermination automatique d'une fonction de transfert adaptée à l'analyse de stabilité du circuit, et un moyen de détermination de la stabilité électrique du circuit à partir des positions des pôles et des zéros de la fonction de transfert déterminé par le moyen de détermination automatique.

Dans la mémoire d'enregistrement, la fonction de transfert est sauvegardée sous la forme d'une première fonction discrète du module de l'impédance ou admittance de transfert en fonction de la fréquence d'analyse et d'une deuxième fonction discrète de la phase de l'impédance ou admittance de transfert en fonction de la fréquence d'analyse.

Chaque sous-bande entoure un extrémum local différent du module de l'impédance en fonction de la fréquence.

La fonction de transfert élémentaire est obtenu à partir de l'impédance ou admittance de transfert restreinte à une sous-bande. Elle a un ordre prédéterminé et est du type utilisé dans les modélisations en automatique,

La moyen de détermination automatique est apte à mettre en oeuvre une boucle d'identification paramétrée selon un ordre de fonction de transfert courant croissant et à activer le moyen d'identification élémentaire en lui fournissant l'ordre de fonction de transfert courant comme ordre prédéterminé.

Le moyen de détermination est apte à arrêter le parcours de la boucle d'identification lorsqu'une norme de la fonction d'erreur de phase associée à la fonction de transfert d'ordre courant a dépassé une valeur de seuil d'erreur de phase prédéterminée.

La fonction d'erreur de phase est l'ensemble des erreurs de phase décrit lorsque la fréquence décrit la sous-bande de rang fixé, l'erreur de phase à une fréquence donnée étant la différence entre la phase de la fonction de transfert identifiée d'ordre courant et la phase de l'impédance ou admittance de transfert.

En variante, le moyen de simulation de l'impédance ou admittance de transfert est un moyen de mesure de l'impédance ou admittance de transfert.

Un produit de programme d'ordinateur comprend des instructions de programme pour mettre en oeuvre les étapes du procédé 2 décrites ci-dessus. Il est par exemple chargé dans une mémoire d'ordinateur, puis ensuite exécuté en se servant de données d'une impédance ou admittance de transfert préalablement chargées dans une mémoire de l'ordinateur.

Le procédé 2 constitue une étape d'un procédé de fabrication d'un circuit électrique dans lequel le circuit électrique est d'abord conçu mécaniquement et électriquement, puis représentée selon un modèle physique.

Les valeurs des fréquences génératrices d'instabilité et les bandes de fréquences stables constituent des caractéristiques physiques propres au circuit.

Le circuit électrique ayant les caractéristiques de stabilité électrique déterminées par le procédé d'analyse 2 est ensuite mis en fonderie pour certains de ses composants et assemblé.

L'étape d'identification automatique 22 d'une fonction de transfert au travers de la boucle 24 et d'un critère d'arrêt et de sortie de la boucle 24 par le dépassement d'un seuil d'une fonction d'erreur de phase permet une mise en oeuvre d'un procédé d'analyse de stabilité de manière complètement automatique.

Il en résulte que des méthodes de simulation de type Monte Carlo peuvent être utilisées. Ces méthodes permettent d'assister la conception et de valider le processus de fabrication industriel d'un circuit électrique de sorte qu'il soit stable électriquement dans une bande de fréquences prédéterminée.

L'étape d'identification peut être mise en oeuvre avec une fonction de transfert d'identification d'ordre pair ou impair.

La présence d'une boucle de limitation de l'ordre $n$ garantit la bonne exécution de la boucle 24 en l'évitant de diverger et une analyse numérique fiable de la stabilité électrique.

De plus, la boucle de limitation diminue le temps d'exécution du procédé.

Le choix de valeurs préférées pour l'ordre maximal n_max de la fonction de transfert à identifier, du nombre de points minimal requis dans l'étape d'affinement 32, de la valeur du rapport de la sous-bande affinée sur la sous-bande en cours d'analyse permet de réduire le temps d'exécution du procédé lorsqu'il est mis en oeuvre par un ordinateur.

**Revendications**

1.  Procédé d'analyse de stabilité électrique d'un circuit actif destiné à fonctionner dans un domaine de fréquences prédéterminé selon un régime linéaire ou non linéaire prédéterminé, mis en oeuvre par un outil d'analyse et comprenant des étapes consistant à :

    à partir d'un modèle physique fourni par un outil logiciel de type CAO du circuit, déterminer (4) une réponse fréquentielle du circuit sous la forme d'une évolution de l'impédance de transfert I(f) ou de l'admittance de transfert A(f) du circuit en fonction de la fréquence, la fréquence décrivant une bande de fréquences discrète d'analyse et la réponse fréquentielle correspondant à la linéarisation du circuit autour de la solution en régime établi,
    enregistrer (6) l'impédance ou l'admittance de transfert I(f) ou A(f) sous la forme d'une première fonction discrète du module (M) de l'impédance ou admittance en fonction de la fréquence d'analyse (f) et d'une deuxième fonction discrète de la phase ($\varphi$) de l'impédance ou admittance en fonction de la fréquence d'analyse (f),
    diviser (8) la bande d'analyse (B) en sous-bandes, chaque sous-bande entourant un extrémum local différent du module (M) de l'impédance ou admittance de transfert I(f) ou A(f),
    ordonner (10) l'ensemble de sous-bandes selon une séquence en affectant un rang à chaque sous-bande,
    dans une étape d'identification élémentaire (36), pour une sous-bande ayant un rang fixé (rang_sb) et un ordre (n) de fonction de transfert prédéterminé :

identifier une fonction de transfert (TFI$_{ranf\_sb}$ (n)) ayant l'ordre prédéterminé (n) proche au sens d'une distance fonctionnelle de l'impédance ou admittance de transfert (I$_{rang\_sb}$ (f))restreinte à la sous-bande de rang fixé lorsque la fréquence décrit la sous-bande de rang fixé,

**caractérisé en ce que** :

pour une sous-bande ayant un rang fixé (rang_sb), le procédé comprend une étape de détermination automatique (22) d'une fonction de transfert ((TFI$_{ranf\_sb}$ (n_opti)) adaptée à l'analyse de stabilité, l'étape de détermination automatique (22) étant exécutée sous la forme d'une boucle d'identification (24) paramétrée selon un ordre de fonction de transfert courant croissant (n) et mettant en oeuvre l'étape d'identification élémentaire (36) dans laquelle l'ordre prédéterminé est l'ordre de la fonction de transfert courant,

**en ce que** chaque étape d'identification élémentaire (36) mise en oeuvre dans la boucle d'identification (24) comprend une étape consistant à calculer une fonction d'erreur de phase err$\varphi$(n) comme étant l'ensemble des erreurs de phase décrit lorsque la fréquence décrit la sous-bande de rang fixé, l'erreur de phase à une fréquence donnée étant la différence entre la phase de la deuxième fonction et la phase de la fonction de transfert identifiée et à déterminer une norme de la fonction d'erreur, et **en ce que** le parcours de la boucle d'identification (24) est arrêté lorsqu'une norme de la fonction d'erreur de phase a dépassé une valeur de seuil d'erreur de phase prédéterminée, et **en ce qu'**il comprend une étape consistant à

déterminer la stabilité électrique du circuit à partir des positions des pôles et des zéros de la fonction de transfert identifiée à l'étape de détermination automatique (22).

2. Procédé d'analyse de stabilité électrique d'un circuit actif selon la revendication 1, **caractérisé en ce qu'**une fonction de transfert d'identification d'ordre n est de rang pair et sa représentation de Laplace T(p) s'écrit sous la forme :

$$T(p) = \frac{a_n p^n + a_{n-1} p^{n-1} + ... + a_1 p + a_0}{b_n p^n + b_{n-1} p^{n-1} + ... + b_1 p + b_0}$$

dans laquelle a$_n$, a$_{n-1}$, ...a$_1$, a$_0$, b$_n$, b$_{n-1}$, ...b$_1$, b$_0$ désignent des coefficients réels et p désigne l'opérateur de Laplace de dérivation temporelle.

3. Procédé d'analyse de stabilité électrique d'un circuit actif selon la revendication 1, **caractérisé en ce qu'**une fonction de transfert d'identification d'ordre n et de rang impair et sa représentation de Laplace T(p) s'écrit sous la forme :

$$T(p) = \frac{a_n p^n + a_{n-1} p^{n-1} + ... + a_1 p + a_0}{b_{n-1} p^{n-1} + b_{n-2} p^{n-2} + ... + b_1 p + b_0}$$

dans laquelle a$_n$, a$_{n-1}$, ...a$_1$, a$_0$, b$_{n-1}$, b$_{n-2}$, ...b$_1$, b$_0$ désignent des coefficients réels et p désigne l'opérateur de Laplace de dérivation temporelle.

4. Procédé d'analyse de stabilité électrique d'un circuit actif selon l'une des revendications 1 à 3, **caractérisé en ce que** la norme de la fonction d'erreur est la valeur absolue maximale de l'erreur de phase sur l'ensemble des erreurs de phase décrit lorsque la fréquence décrit la sous-bande de rang fixé.

5. Procédé d'analyse de stabilité électrique d'un circuit actif selon l'une des revendications 1 à 3, **caractérisé en ce que** la boucle (24) est arrêtée lorsque la norme de la fonction d'erreur est inférieure à une valeur de seuil comprise entre 10$^{-5}$ et 10$^{-1}$, et de préférence égale à 0,001.

6. Procédé d'analyse de stabilité électrique d'un circuit actif selon la revendication 1 à 5, **caractérisé en ce qu'**il comprend une boucle de limitation (43) de l'ordre de la fonction de transfert déterminée automatiquement dans la boucle d'identification automatique (24) lorsque l'ordre courant (n) dépasse une valeur prédéterminée (n_max), la boucle de limitation (43) comportant les étapes consistant à :

interrompre (42) la boucle d'identification automatique (24),
découper (62) la sous-bande de rang fixé en deux sous-bandes de plus petite taille, et
mettre à jour (64) la séquence d'ordonnancement de sous-bandes en affectant le rang déjà fixé à une première des sous-bandes obtenues par division et le rang déjà fixé incrémenté d'une unité à la deuxième des sous-bandes obtenues par division restante, et en décalant le rang des sous-bandes restantes dont le rang est supérieur au rang fixé d'une unité, et
**en ce qu'**il comprend une étape consistant à mettre en oeuvre la boucle d'identification pour la première sous-bande obtenue par division à l'étape (62).

**7.** Procédé d'analyse de stabilité électrique selon l'une des revendications 1 à 6, caractérisé en qu'il comprend les étapes consistant à
lorsque le critère d'arrêt fondé sur le franchissement de la valeur de seuil d'erreur de phase prédéterminé est satisfait, déterminer (30) les pôles et les zéros complexes de la fonction de transfert identifiée automatiquement, et,
dans une étape (32), lorsqu'il existe un pole et un zéro à partie réelle positive proche d'au moins une distance seuil dans le plan complexe prédéterminée, restreindre (32) la sous-bande de rang fixé en cours d'analyse à une bande d'analyse affinée centrée sur l'extrémum local de la sous-bande en cours d'analyse et de largeur relative par rapport à la largeur de la sous-bande égale à une valeur prédéterminée.

**8.** Procédé d'analyse de stabilité électrique selon la revendication 7, **caractérisé en ce que** dans l'étape (32) lorsqu'il existe un nombre de points de l'impédance ou admittance de transfert dans la sous-bande affinée au moins égal à une valeur prédéterminée, le rang fixé est affecté à la sous-bande affinée, et une boucle d'identification automatique du même type que la boucle (24) est mise en oeuvre dans la sous-bande affinée, puis les pôles et les zéros complexes de la fonction de transfert identifiée automatiquement dans la sous-bande affinée sont déterminés, et il est vérifié s'il existe toujours une instabilité.

**9.** Procédé d'analyse de stabilité électrique selon la revendication 8, **caractérisé en ce que** dans l'étape (32) lorsque le nombre de points dans la sous-bande affinée est inférieur ou égale à la valeur prédéterminée alors cette bande est étendue jusqu'à ce que son nombre de points soit égal à la valeur prédéterminée.

**10.** Procédé d'analyse de stabilité électrique selon l'une des revendications 1 à 7, **caractérisé en ce qu'**il comprend une boucle (12) dans laquelle les sous-bandes sont balayées en faisant varier le rang affecté à chacune d'entre elles et la stabilité électrique dans chaque sous-bande est analysé.

**11.** Procédé de fabrication d'un circuit électrique comprenant les étapes consistant à
concevoir mécaniquement et électriquement un circuit électrique et le représenter par un modèle physique,
valider la stabilité électrique du circuit par le procédé défini selon l'une des revendications 1 à 10,
réaliser le circuit électrique ayant les caractéristiques de stabilité électrique déterminées dans le procédé d'analyse défini selon l'une des revendications 1 à 10.

**12.** Produit programme d'ordinateur comprenant des instructions de programme pour mettre en oeuvre les étapes de procédé selon l'une des revendications 1 à 10 lorsque ledit programme fonctionne sur un ordinateur.

**13.** Outil d'analyse de stabilité électrique d'un circuit actif destiné à fonctionner dans un domaine de fréquences prédéterminé selon un régime linéaire ou non linéaire prédéterminé, comprenant :

un outil logiciel de type CAO du circuit, apte à déterminer (4), à partir d'un modèle physique, une réponse fréquentielle du circuit sous la forme d'une évolution de l'impédance ou admittance de transfert I(f) ou A(f) du circuit en fonction de la fréquence, la fréquence décrivant une bande de fréquences discrète d'analyse et la réponse fréquentielle correspondant à la linéarisation du circuit autour de la solution de l'état établi,
une mémoire pour enregistrer l'impédance de transfert I(f) ou admittance de transfert A(f) sous la forme d'une première fonction discrète du module (M) de l'impédance en fonction de la fréquence d'analyse (f) et d'une deuxième fonction discrète de la phase ($\varphi$) de l'impédance en fonction de la fréquence d'analyse (f),
un moyen de division de la bande d'analyse (B) en sous-bandes, chaque sous-bande entourant un extrémum local différent du module (M) de l'impédance ou admittance de transfert I(f) ou A(f),
un moyen d'ordonnancement (10) de l'ensemble de sous-bandes selon une séquence en affectant un rang à chaque sous-bande,
un moyen d'identification élémentaire (36) apte à, pour une sous-bande ayant un rang fixé (rang_sb) et un ordre (n) de fonction de transfert prédéterminé identifier une fonction de transfert ($TFI_{ranf\_sb}$ (n)) ayant l'ordre prédéterminé (n) proche au sens d'une distance fonctionnelle de l'impédance ou admittance de transfert ($I_{rang\_sb}$ (f)) restreinte à la sous-bande de rang fixé lorsque la fréquence décrit la sous-bande de rang fixé,
**caractérisé en ce qu'**il comprend :

un moyen de détermination automatique (22) d'une fonction de transfert (($TFI_{ranf\_sb}$ (n_opti)) adaptée à l'analyse de stabilité, pour une sous-bande ayant un rang fixé (rang_sb) apte à exécuter une boucle d'identification (24) paramétrée selon un ordre de fonction de transfert courant croissant (n) et à activer le moyen d'identification élémentaire (36) en lui fournissant l'ordre de la fonction de transfert courant comme ordre prédéterminé,
le moyen d'identification élémentaire (36) étant apte à calculer une fonction d'erreur de phase err$\varphi$(n) comme étant l'ensemble des erreurs de phase décrit lorsque la fréquence décrit la sous-bande de rang fixé, l'erreur de phase à une fréquence donnée étant la différence entre la phase de la deuxième fonction et la phase de la fonction de transfert identifiée et à déterminer une norme de la fonction d'erreur, et **en ce que** le moyen de détermination automatique (22) est apte à arrêter la boucle d'identification automatique (24) lorsque la norme de la fonction d'erreur de phase a dépassé une valeur de seuil d'erreur de phase prédéterminée, et **en ce qu'**il comprend un moyen de détermination de la stabilité électrique du circuit à partir des positions des pôles et des zéros de la fonction de transfert identifiée à l'étape de détermination automatique (22).

**Patentansprüche**

1. Verfahren, ausgeführt von einem Werkzeug zur Analyse, zur Analyse von elektrischer Stabilität einer aktiven Schaltung, vorgesehen zum Arbeiten in einem vorgegebenen Frequenzbereich gemäß einer vorgegebenen linearen oder nichtlinearen Betriebsart aufweisend Schritte bestehend aus:

   Ausgehend von einem physikalischen Modell, bereitgestellt von einem Software-Werkzeug vom Typ CAD der Schaltung, Ermitteln (4) einer Frequenzantwort der Schaltung in der Form einer Änderung der Transferimpedanz I(f) oder -admittanz A(f) der Schaltung in Abhängigkeit der Frequenz, wobei die Frequenz ein diskretes Analysefrequenzband beschreibt und die Frequenzantwort der Linearisierung der Schaltung um die Lösung im stationären Zustand entspricht,
   Speichern (6) der Transferimpedanz oder -admittanz I(f) oder A(f) in der Form einer ersten diskreten Funktion des Betrages (M) der Impedanz oder Admittanz in Abhängigkeit der Analysefrequenz (f) und einer zweiten diskreten Funktion der Phase ($\varphi$) der Impedanz oder Admittanz in Abhängigkeit der Analysefrequenz (f),
   Teilen (8) des Analysebands (B) in Sub-Bänder, wobei jedes Sub-Band ein anderes lokales Extremum des Moduls (M) der Transferimpedanz oder -admittanz I(f) oder A(f) umgibt,
   Ordnen (10) der Menge von Sub-Bändern gemäß einer Reihenfolge unter Bestimmen eines Rangs für jedes Sub-Band,
   in einem Schritt einer elementaren Identifikation (36), für jedes Sub-Band mit einem festen Rang (rang_sb) und einer vorgegebenen Transferfunktionsordnung (n):

   Identifizieren einer Transferfunktion (TFI$_{ranf\_sb}$(n)), die die vorgegebene Ordnung (n) nahe im Sinne einer funktionellen Distanz an der Transferimpedanz oder -admittanz (I$_{rang\_sb}$ (f)) hat, eingeschränkt auf das Sub-Band des festen Rangs, wenn die Frequenz das Sub-Band des festen Rangs beschreibt,
   dadurch charakterisiert, dass
   für ein Sub-Band mit einem festen Rang (rang_sb) das Verfahren einen Schritt der automatischen Ermittlung (22) einer Transferfunktion ((TFI$_{ranf\_sb}$ (n_opti)), die an die Stabilitätsanalyse angepasst ist, aufweist, wobei der Schritt der automatischen Ermittlung (22) in der Form einer Identifikationsschleife (24) ausgeführt wird, die gemäß einer zunehmenden aktuellen Transferfunktionsordnung (n) parametrisiert ist, und den Schritt der elementaren Identifikation (36) ausführt, in dem die vorgegebene Ordnung die Ordnung der aktuellen Transferfunktion ist,
   dadurch, dass jeder Schritt der elementaren Identifikation (36), der in der Identifikationsschleife (24) ausgeführt wird, einen Schritt aufweist, der im Berechnen einer Phasenfehlerfunktion err$\varphi$ (n) als die Menge der beschriebenen Phasenfehler, wenn die Frequenz das Sub-Band des festen Rangs beschreibt, wobei der Phasenfehler an einer gegebenen Frequenz der Unterschied zwischen der Phase der zweiten Funktion und der Phase der identifizierten Transferfunktion ist, und im Ermitteln einer Norm der Fehlerfunktion besteht, und dadurch, dass das Durchlaufen der Identifikationsschleife (24) angehalten wird, wenn eine Norm der Phasenfehlerfunktion einen vorgegebenen Phasenfehlerschwellwert überschreitet und dadurch, dass es einen Schritt aufweist bestehend aus
   Ermitteln der elektrischen Stabilität der Schaltung ausgehend von den Positionen der Polen und der Nullstellen der in dem Schritt der automatischen Ermittlung (22) identifizierten Transferfunktion.

2. Verfahren zur Analyse von elektrischer Stabilität einer aktiven Schaltung gemäß Anspruch 1, dadurch charakterisiert, dass eine Identifikationstransferfunktion von der Ordnung n einen geraden Rang hat und ihre Laplace-Darstellung T(p) sich in der Form schreiben lässt:

$$T(p) = \frac{a_n p^n + a_{n-1} p^{n-1} + ... + a_1 p + a_0}{b_n p^n + b_{n-1} p^{n-1} + ... b_1 p + b_0}$$

in der $a_n$, $a_{n-1}$, ...$a_1$, $a_0$, $b_n$, $b_{n-1}$, ...$b_1$, $b_0$ reelle Koeffizienten bezeichnen und p den Laplace-Operator der zeitlichen Ableitung bezeichnet.

3. Verfahren zur Analyse von elektrischer Stabilität einer aktiven Schaltung gemäß Anspruch 1, dadurch charakterisiert, dass eine Identifikationstransferfunktion von der Ordnung n einen ungeraden Rang hat und ihre Laplace-Darstellung T(p) sich in der Form schreiben lässt:

$$T(p) = \frac{a_n p^n + a_{n-1} p^{n-1} + ... + a_1 p + a_0}{b_{n-1} p^{n-1} + b_{n-2} p^{n-2} + ... b_1 p + b_0}$$

in der $a_n$, $a_{n-1}$, ...$a_1$, $a_0$, $b_{n-1}$, $b_{n-2}$, ...$b_1$, $b_0$ reelle Koeffizienten bezeichnen und p den Laplace-Operator der zeitlichen Ableitung bezeichnet.

4. Verfahren zur Analyse von elektrischer Stabilität einer aktiven Schaltung gemäß einem der Ansprüche 1 bis 3, dadurch charakterisiert, dass die Norm der Fehlerfunktion der maximale Absolutwert des Phasenfehlers über die Menge der Phasenfehler ist, die beschrieben werden, wenn die Frequenz das Sub-Band mit festen Rang beschreibt.

5. Verfahren zur Analyse von elektrischer Stabilität einer aktiven Schaltung gemäß einem der Ansprüche 1 bis 3, dadurch charakterisiert, dass die Schleife (24) angehalten wird, wenn die Norm der Fehlerfunktion unter einem Schwellwert liegt, der zwischen $10^{-5}$ und $10^{-1}$ liegt und bevorzugt gleich 0,001 ist.

6. Verfahren zur Analyse von elektrischer Stabilität einer aktiven Schaltung gemäß einem der Ansprüche 1 bis 3, dadurch charakterisiert, dass es aufweist eine Schleife der Beschränkung (43) der Ordnung der in der Schleife der automatischen Identifikation (24) automatisch ermittelten Transferfunktion, wenn die aktuelle Ordnung (n) einen vorgegebenen Wert (n_max) überschreitet, wobei die Schleife zur Beschränkung (43) die Schritte aufweist bestehend aus:

Unterbrechen (42) der Schleife der automatischen Identifikation (24),
Aufteilen (62) des Sub-Bands mit festem Rang in zwei Sub-Bänder mit kleinerer Größe, und
Aktualisieren (64) der Sub-Bänder-Ordnungsreihenfolge durch Zuweisen des schon festen Rangs an ein erstes der durch Teilen erhaltenen Sub-Bänder und des schon festen Rangs erhöht um eine Einheit zu dem verbleibenden zweiten der Sub-Bänder und durch Verschieben des Rangs der verbleibenden Sub-Bänder deren Rang um eine Einheit größer ist als der feste Rang und
dadurch, dass es einen Schritt, bestehend aus dem Ausführen der Identifikationsschleife für das erste durch das Teilen in dem Schritt (62) erhaltene Sub-Band aufweist.

7. Verfahren zur Analyse von elektrischer Stabilität einer aktiven Schaltung gemäß einem der Ansprüche 1 bis 6, dadurch charakterisiert, dass es die Schritte aufweist bestehend aus
wenn das Haltekriterium basierend auf dem Überschreiten des vorgegebenen Phasenfehlerschwellwerts erfüllt ist, Ermitteln (30) der komplexen Pole und Nullstellen der automatisch identifizierten Transferfunktion und
in einem Schritt (32), wenn ein Pol und eine Nullstelle mit positivem Realteil existieren, die nah an mindestens einem Schwellwertabstand in der vorgegebenen komplexen Ebene sind, Beschränken (32) des Sub-Bands mit festem Rang im Laufe der Analyse auf ein verfeinertes Analyseband, das um das lokale Extremum des Sub-Bands im Laufe der Analyse zentriert ist und eine relative Breite bezüglich der Bereite des Sub-Bands gleich einem vorgegebenen Wert hat.

8. Verfahren zur Analyse von elektrischer Stabilität einer aktiven Schaltung gemäß Anspruch 7, dadurch charakterisiert, dass in dem Schritt (32), wenn eine Anzahl von Punkten der Transferimpedanz oder -admittanz in dem verfeinerten Sub-Band mindestens gleich einem vorgegebenen Wert existiert, der feste Rang dem verfeinerten Sub-Band zugewiesen wird und eine Schleife der automatischen Identifikation vom selben Typ wie die Schleife (24) in dem verfeinerten Sub-Band ausgeführt wird, dann die komplexen Pole und Nullstellen der automatisch identifizierten Transferfunktion in dem verfeinerten Sub-Band ermittelt werden und es verifiziert wird, ob immer noch eine Instabilität existiert.

9. Verfahren zur Analyse von elektrischer Stabilität einer aktiven Schaltung gemäß Anspruch 8, dadurch charakterisiert, dass
in dem Schritt (32), wenn die Anzahl von Punkten in dem verfeinerten Sub-Band kleiner oder gleich einem vorgegebenen Wert ist, dann dieses Band erweitert wird, bis seine Anzahl von Punkten gleich einem vorgegebenen Wert ist.

10. Verfahren zur Analyse von elektrischer Stabilität einer aktiven Schaltung gemäß einem der Ansprüche 1 bis 7, dadurch charakterisiert, dass es eine Schleife (12) aufweist, in der die Sub-Bänder abgetastet werden, wobei der Rang, der jedem von ihnen zugewiesen ist, variiert wird und die elektrische Stabilität in jedem Sub-Band analysiert wird.

11. Verfahren zur Herstellung einer elektrischen Schaltung aufweisend die Schritte bestehend aus mechanischem und elektrischem Entwerfen einer elektrischen Schaltung und sie Darstellen mittels eines physikalischen Modells, Validieren der elektrischen Stabilität der Schaltung durch das gemäß einem der Ansprüche 1 bis 10 definierte Verfahren, Realisieren der elektrischen Schaltung mit den in dem gemäß einem der Ansprüche 1 bis 10 definierten Verfahren ermittelten elektrischen Stabilitätseigenschaften.

12. Computerprogrammprodukt, aufweisend Programminstruktionen, um die Schritte des Verfahrens gemäß einem der Ansprüche 1 bis 10 auszuführen, wenn das Programm auf einem Computer läuft.

13. Werkzeug zur Analyse von elektrischer Stabilität einer aktiven Schaltung, vorgesehen zum Arbeiten in einem vorgegebenen Frequenzbereich gemäß einer vorgegebenen linearen oder nichtlinearen Betriebsart aufweisend:

ein Software-Werkzeug vom Typ CAD der Schaltung, geeignet zum Ermitteln, ausgehend von einem physikalischen Modell, einer Frequenzantwort der Schaltung in der Form einer Änderung der Transferimpedanz I(f) oder -admittanz A(f) der Schaltung in Abhängigkeit der Frequenz, wobei die Frequenz ein diskretes Analysefrequenzband beschreibt und die Frequenzantwort der Linearisierung der Schaltung um die Lösung im stationären Zustand entspricht,
einen Speicher zum Speichern der Transferimpedanz oder -admittanz I(f) oder A(f) in der Form einer ersten diskreten Funktion des Betrages (M) der Impedanz oder Admittanz in Abhängigkeit der Analysefrequenz (f) und einer zweiten diskreten Funktion der Phase ($\varphi$) der Impedanz oder Admittanz in Abhängigkeit der Analysefrequenz (f),
ein Mittel zum Teilen des Analysebands (B) in Sub-Bänder, wobei jedes Sub-Band ein anderes lokales Extremum des Moduls (M) der Transferimpedanz oder -admittanz I(f) oder A(f) umgibt,
ein Mittel zum Ordnen (10) der Menge von Sub-Bändern gemäß einer Reihenfolge unter Bestimmen eines Rangs für jedes Sub-Band,
ein Mittel zur elementaren Identifikation (36), geeignet zum, für jedes Sub-Band mit einem festen Rang (rang-sb) und einer vorgegebenen Transferfunktionsordnung (n), Identifizieren einer Transferfunktion (TFI$_{ranf\_sb}$ (n)), die die vorgegebene Ordnung (n) nahe im Sinne einer funktionellen Distanz an der Transferimpedanz oder -admittanz (I$_{rang\_sb}$ (f)), hat, eingeschränkt auf das Sub-Band des festen Rangs, wenn die Frequenz das Sub-Band des festen Rangs beschreibt,
dadurch charakterisiert, dass es aufweist:

Ein Mittel zur automatischen Ermittlung (22) für ein Sub-Band mit einem festen Rang (rang_sb) einer Transferfunktion ((TFI$_{ranf\_sb}$ (n_opti)), die an die Stabilitätsanalyse angepasst ist, geeignet zum Ausführen einer Identifikationsschleife (24), die gemäß einer zunehmenden aktuellen Transferfunktionsordnung (n) parametrisiert ist, und zum Aktivieren des Mittels zur elementaren Identifikation (36), wobei es ihm die Ordnung der aktuellen Transferfunktion als vorgegebene Ordnung liefert, wobei das Mittel zur elementaren Identifikation (36) zum Berechnen einer Phasenfehlerfunktion err$\varphi$ (n) als die Menge der beschriebenen Phasenfehler, wenn die Frequenz das Sub-Band des festen Rangs beschreibt, wobei der Phasenfehler an einer gegebenen Frequenz der Unterschied zwischen der Phase der zweiten Funktion und der Phase der identifizierten Transferfunktion ist und zum Ermitteln einer Norm der Fehlerfunktion geeignet ist, und dadurch, dass
das Mittel zum automatischen Ermitteln (22) zum Anhalten der Schleife zum automatischen Identifizieren (24) geeignet ist, wenn eine Norm der Phasenfehlerfunktion einen vorgegebenen Phasenfehlerschwellwert überschreitet und dadurch, dass es ein aufweist
ein Mittel zum Ermitteln der elektrischen Stabilität der Schaltung ausgehend von den Positionen der Pole und der Nullstellen der in dem Schritt der automatischen Ermittlung (22) identifizierten Transferfunktion.

**Claims**

1. A method for analyzing the electrical stability of an active circuit intended to operate in a predetermined frequency domain according to a predetermined linear or nonlinear operating condition, implemented by a tool for analyzing and comprising the following steps:

starting from a physical model provided by a CAD-type software tool for the circuit, determining (4) a frequency response of the circuit in the form of an evolution of the transfer impedance I(f) or the transfer admittance A(f) of the circuit as a function of the frequency, the frequency describing a discrete analysis frequency band and the frequency response corresponding to the linearization of the circuit around the solution in a steady state,

recording (6) the transfer impedance or admittance I(f) or A(f) in the form of a first discrete function of the module (M) of the impedance or admittance as a function of the analysis frequency (f) and a second discrete function of the phase ($\varphi$) of the impedance or admittance as a function of the analysis frequency (f),

dividing (8) the analysis band (B) into sub-bands, each sub-band surrounding a different local extremum of the module (M) of the transfer impedance or admittance I(f) or A(f),

ordering (10) the set of sub-bands following a sequence while assigning a rank to each sub-band,

in an elementary identification step (36), for a sub-band having a fixed rank (rang_sb) and a predetermined transfer function order (n):

identifying a transfer function ($TFI_{ranf\_sb}(n)$) having the predetermined order (n) close in terms of a functional distance to the transfer impedance or admittance ($I_{rang\_sb}(f)$) restricted to the fixed-rank sub-band when the frequency describes the fixed sub-band,

**characterized in that**:

for a sub-band having a fixed rank (rang_sb), the method comprises a step (22) for automatically determining a transfer function (($TFI_{ranf\_sb}(n\_opti)$) adapted to the stability analysis, the automatic determination step (22) being carried out in the form of an identification loop (24) parameterized according to an increasing current transfer function order (n) and implementing the elementary identification step (36) in which the predetermined order is the order of the current transfer function,

**in that** each elementary identification step (36) implemented in the identification loop (24) comprises a step consisting of calculating a phase error function $err\varphi(n)$ as being the set of phase errors described when the frequency describes the fixed-rank sub-band, the phase error at a given frequency being the difference between the phase of the second function and the identified transfer phase, and determining a norm for the error function, and **in that**

the path of the identification loop (24) is stopped when a norm of the phase error function has exceeded a predetermined phase error threshold value, and **in that** it comprises a step consisting of

determining the electrical stability of the circuit from the positions of the poles and the zeros of the transfer function identified in the automatic determination step (22).

2. The method for analyzing the electrical stability of an active circuit according to claim 1, **characterized in that** an identification transfer function of order n is even and its Laplace transform T(p) is written:

$$T(p) = \frac{a_n p^n + a_{n-1} p^{n-1} + ... + a_1 p + a_0}{b_n p^n + b_{n-1} p^{n-1} + ... + b_1 p + b_0}$$

in which $a_n$, $a_{n-1}$, ...$a_1$, $a_0$, $b_n$, $b_{n-1}$, ...$b_1$, $b_0$ designate real coefficients and p designates the temporal drift Laplace operator.

3. The method for analyzing the electrical stability of an active circuit according to claim 1, **characterized in that** an identification transfer function of order n is odd and its Laplace transform T(p) is written:

$$T(p) = \frac{a_n p^n + a_{n-1} p^{n-1} + ... + a_1 p + a_0}{b_{n-1} p^{n-1} + b_{n-2} p^{n-2} + ... + b_1 p + b_0}$$

in which $a_n$, $a_{n-1}$, ...$a_1$, $a_0$, $b_{n-1}$, $b_{n-2}$, ...$b_1$, $b_0$ designate real coefficients and p designates the temporal drift Laplace operator.

4. The method for analyzing the electrical stability of an active circuit according to claim 1, **characterized in that** the norm of the error function is the maximum absolute value of the phase error over the set of phase errors described when the frequency describes the fixed-rank sub-band.

5. The method for analyzing the electrical stability of an active circuit according to claim 1, **characterized in that** the loop (24) is stopped when the norm of the error function is below a threshold value between $10^{-5}$ and $10^{-1}$, and preferably equal to 0.001.

6. The method for analyzing the electrical stability of an active circuit according to claim 1, **characterized in that** it comprises

a limiting loop (43) of the order of the transfer function automatically determined in the automatic identification loop (24) when the current order (<u>n</u>) exceeds a predetermined value (n_max), the limiting loop (43) including the following steps:

interrupting (42) the automatic identification loop (24),

splitting (62) the fixed-rank sub-band into two smaller sub-bands, and

updating (64) the sub-band ordering sequence by allocating the rank already set to a first of the sub-bands obtained by splitting and the rank already set incremented by one unit to the second of the sub-bands obtained by division remaining, and by offsetting the rank of the remaining sub-bands, the rank of which is greater than the fixed rank by one unit, and

**in that** it comprises a step consisting of implementing the identification loop for the first sub-band obtained by division in the step (62) for splitting the fixed-rank sub-band.

7. The method for analyzing the electrical stability of an active circuit according to claim 1, **characterized in that** comprises the following steps:

when the stop criterion based on crossing the predetermined phase error threshold value is met, determining (30) the complex poles and zeros of the automatically identified transfer function, and

in a step (32), when a pole and a zero exist with a positive real part close to at least one threshold distance in the predetermined complex plane, restricting (32) the fixed-rank sub-band being analyzed to a refined analysis band centered on the local extremum of the sub-band being analyzed and with a relative width in relation to the width of the sub-band equal to a predetermined value.

8. The method for analyzing the electrical stability of an active circuit according to claim 7, **characterized in that** in step (32) when a number of points of the transfer impedance or admittance exists in the refined sub-band that is at least equal to a predetermined value, the fixed rank is allocated to the refined sub-band, and an automatic identification loop of the same type as the loop (24) is implemented in the refined sub-band, then the complex poles and zeros of the transfer function automatically identified in the refined sub-band are determined, and it is verified whether an instability still exists.

9. The method for analyzing the electrical stability of an active circuit according to claim 8, **characterized in that** in step (32) when the number of points in the refined sub-band is less than or equal to the predetermined value, then that band is extended until its number of points is equal to the predetermined value.

10. The method for analyzing the electrical stability of an active circuit according to claim 1, **characterized in that** it comprises a loop (12) in which the sub-bands are scanned by varying the rank allocated to each of them and the electrical stability in each sub-band is analyzed.

11. A method of making an electrical circuit comprising the following steps:

mechanically and electrically designing an electrical circuit and representing it via a physical model,

validating the electrical stability of the circuit using the method according to claim 1,

making the electrical circuit having the electrical stability characteristics defined in the analysis method according to claim 1.

12. A computer program product comprising program instructions to carry out the steps of the method according to claim 1 when said program is operating on a computer.

13. A tool for analyzing the electrical stability of an active circuit intended to operate in a predetermined frequency domain according to a predetermined linear or nonlinear operating condition, comprising:

a software tool of the CAD type for the circuit, capable of determining (4), from a physical model, a frequency response of the circuit in the form of an evolution of the transfer impedance or admittance I(f) or A(f) of the circuit as a function of the frequency, the frequency describing a discrete analysis frequency band and the frequency response corresponding to the linearization of the circuit around the solution of the established state,

a memory for recording the transfer impedance I(f) or transfer admittance A(f) in the form of a first discrete function of the module (M) of the impedance as a function of the analysis frequency (f) and a second discrete function of the phase ($\varphi$) of the impedance as a function of the analysis frequency (f),

a means for splitting the analysis band (B) into sub-bands, each sub-band surrounding a different local extremum of the module (M) of the transfer impedance or admittance I(f) or A(f),

a means (10) for ordering the set of sub-bands according to a sequence by allocating a rank to each sub-band,

an elementary identification means (36) capable, for a sub-band having a fixed rank (rang_sb) and a predetermined transfer function order (n), of identifying a transfer function ($TFI_{ranf\_sb}$ (n)) having the predetermined order (n) close to the direction of a functional distance of the transfer impedance or admittance ($I_{rang\_sb}$ (f)) restricted to the fixed-rank sub-band when the frequency describes the fixed-rank sub-band, **characterized in that** it comprises:

a means (22) for automatically determining a transfer function (($TFI_{ranf\_sb}$ (n_opti)) adapted to the stability analysis, for a sub-band having a fixed rank (rang_sb) capable of executing an identification loop (24) parameterized according to an increasing current transfer function order (n) and activating the elementary identification means (36) by providing it with the order of the current transfer function as predetermined order, the elementary identification means (36) being capable of calculating a phase error function err$\varphi$(n) as being the set of phase errors described when the frequency describes the fixed-rank sub-band, the phase error at a given frequency being the difference between the phase of the second function and the phase of the identified transfer function and determining a norm of the error function, and **in that** the automatic determination means (22) is capable of stopping the automatic identification loop (24) when the norm of the phase error function has exceeded a predetermined phase error threshold, and **in that** it comprises means for determining the electrical stability of the circuit from the positions of the poles and zeros of the transfer function identified in the automatic determination step (22).

2

| Détermination de l'impédance de transfert | 4 |

| Enregistrement de l'impédance de transfert | 7 |

| Division de la bande d'analyse en sous-bandes | 8 |

| Affectation d'un rang de sous-bande | 10 |

12

| Initialisation rang_sb | 14 |

16

Rang_sb $\leqslant$ NB_sous_bande  non → | FIN | 18

20

oui

| Initialisation de n | 34    24

22

n $\leqslant$ n_max?    42

36

| Flag_identif=0 |    | Détermination FTI$_{rang\_sb}$ (n) |    | n+1 | 40

60

| err $\phi$ | < $10^{-3}$?    38

| Rang_sb+1 |

50

| Mise à jour ordonnancement | 64

| Rang_sb+1 |

62

| Flag_identif=1 |    26

43

Flag_identif=1?    28

oui

vers l'étape 30

de l'étape 32

**FIG.1 début**

vers l'étape 50                            de l'étape 28

non       Analyse des pôles et zéros (position relative entre pôles et zéros insables <5%)  30

oui

Analyse d'une sous-bande affinée  32

# FIG.1 fin

$\epsilon(f)$

$e_0(f_0, P_0)$

6

I(f)

5

s(f)

# FIG.2

FIG.3

FIG.4

## FIG.5

## FIG.6

**FIG.7**